# DEMANDE DE BREVET EUROPEEN

(11) **EP 1 475 833 A1**
(43) Date de publication de la demande: **10.11.2004**
(21) Numéro de dépôt: 04290821.0
(22) Date de dépôt: 29.03.2004
(51) Int. Cl.: H01L 23/528, H01L 23/544

(54) **Circuit intégré comprenant au moins un niveau de métallisation**

(30) Priorité: 05.05.2003 FR 0305433
(71) Demandeur: STMicroelectronics S.A., 92120 Montrouge (FR)
(72) Inventeur: Vallet, Michel, 38410 Vaulnaveys le Haut (FR)
(74) Mandataire: Casalonga, Axel

(57) **Abrégé**

Circuit intégré 1 comprenant au moins un niveau de métallisation, équipé de conducteurs flottants 3. Au moins une partie des conducteurs flottants 3 présente une forme orientée réalisée à partir de rectangles non parallèles en contact mutuel.

## Description

La présente invention relève du domaine des circuits intégrés et de leur procédé de fabrication.

De façon classique, les circuits intégrés sont surmontés d'une pluralité de couches d'interconnexion comprenant une alternance de couches conductrices aussi appelées "niveaux de métallisation" pourvues de lignes conductrices métallisées s'étendant parallèlement à ladite couche et de couches isolantes traversées par des vias conducteurs permettant une connexion électrique entre deux niveaux de métallisation.

Un niveau de métallisation comprend une pluralité de lignes conductrices entourées par des régions réalisées en matériau diélectrique. La densité locale de métal due à la présence des lignes conductrices, peut varier très fortement au sein d'un même niveau de métallisation. Or, une densité faible de métal dans une zone localisée d'un niveau de métallisation pose des problèmes de fabrication.

Lorsque les lignes conductrices sont réalisées à base d'aluminium, il est procédé au dépôt d'une couche d'aluminium sur une couche diélectrique. La couche d'aluminium est ensuite gravée pour ne laisser subsister que les lignes conductrices. Puis, une couche de matériau diélectrique, par exemple de l'oxyde de silicium, est déposée pour remplir les espaces vides laissés entre les lignes conductrices et assurer leur isolation mutuelle et pour former une couche diélectrique au-dessus du niveau de métallisation considéré.

Une étape de polissage mécano-chimique, dit « CMP », est ensuite mise en oeuvre pour diminuer les inégalités d'épaisseur du matériau diélectrique et obtenir une surface plane, de façon que les niveaux de métallisation supérieurs puissent être formés convenablement. Or, lors du dépôt du matériau diélectrique, l'absence de métal dans une zone localisée se traduit par un creux dans la surface supérieure de la couche diélectrique déposée, creux qui peut être si important que le polissage mécano-chimique ne parvient pas à égaliser la surface de la couche diélectrique. Il en résulte un creux subsistant, qui nuit gravement aux étapes ultérieures de fabrication.

Dans le cas où les lignes conductrices seraient réalisées en cuivre, il est procédé à la gravure de l'emplacement des futures lignes conductrices dans une couche épaisse de matériau diélectrique, puis à leur remplissage par du cuivre, puis à un polissage mécano-chimique de la surface supérieure du circuit en cours de fabrication, afin d'ôter le cuivre excédentaire et de parvenir à une surface plane où affleurent les lignes conductrices.

Dans le cas où une zone localisée est dépourvue de cuivre, il risque de subsister, à l'issue du polissage mécano-chimique, une surépaisseur de matériau diélectrique que le polissage ne sera pas parvenu à éliminer.

Comme précédemment, cette inégalité de surface présente des inconvénients graves pour les étapes ultérieures de fabrication du circuit intégré.

Pour remédier à ce problème, il est connu d'insérer des conducteurs flottants, appelés « dummy », inutiles sur le plan électrique, dans les zones de faible densité métallique d'un niveau de métallisation. L'ensemble du niveau de métallisation présente alors une densité de métal relativement homogène, ce qui optimise l'efficacité des procédés de fabrication. Les conducteurs flottants prennent d'autant plus d'importance que les lignes conductrices sont de largeur de plus en plus faible afin d'accroître la densité des interconnexions. Mais la présence de tels conducteurs flottants modifie les caractéristiques électriques des interconnexions qu'ils entourent en formant des capacités parasites, au risque de compromettre le bon fonctionnement de l'ensemble du circuit intégré, et ce, d'autant plus que les lignes conductrices sont de faible largeur.

L'évolution technologique qui tend à augmenter la densité d'intégration et donc à réduire la largeur des lignes conductrices, rend les circuits de plus en plus sensibles du point de vue électrique à la présence des conducteurs flottants. L'augmentation de la fréquence d'horloge des circuits intégrés rend ceux-ci plus sensibles aux capacités parasites, notamment à cause des durées de propagation accrus qu'elles provoquent.

Les conducteurs flottants se présentent en général sous la forme de plots carrés dans les zones de faible densité métallique d'un niveau de métallisation. On pourrait envisager de diminuer les dimensions des conducteurs flottants afin de réduire la capacité parasite qu'ils forment avec les lignes voisines. Toutefois, la fabrication d'un très grand nombre de conducteurs flottants de petite dimension présente des inconvénients en termes de simplicité des circuits et de rendement de fabrication. La présence d'un très grand nombre de conducteurs flottants de petite dimension est gênante pour effectuer une analyse de défaillances postérieure à la fabrication, en raison de l'écran formé qui bloque les images photoniques et plus généralement la transmission de tous type de photons, par exemple en technologie HCMOS 9. Peuvent être gênés, la visualisation par faisceau d'ions focalisés, la modification du circuit par moyen laser, la microscopie infrarouge, l'observation optique microscopique, le marquage laser, etc.

L'invention vise à proposer un circuit intégré à conducteurs flottants dont l'analyse de défaillance est possible malgré une technologie avancée.

L'invention vise à proposer un circuit intégré dont les conducteurs flottants sont aptes à servir de marques d'alignement.

L'invention propose un circuit intégré comprenant au moins un niveau de métallisation pourvu de conducteurs flottants. Au moins une partie des conducteurs flottants présente une forme orientée réalisée à partir de rectangles non parallèles en contact mutuel.

On peut ainsi réduire la densité de conducteurs flottants d'où une meilleure visibilité des structures disposées sous lesdits conducteurs flottants. Le polissage ne s'en trouve pas gêné.

Les conducteurs flottants peuvent être disposés au niveau de plots métallisés.

Avantageusement, les conducteurs flottants consistent en deux rectangles perpendiculaires. Un petit côté de l'un des rectangles est en contact continu avec un grand côté de l'autre rectangle. Les deux rectangles peuvent être d'égales dimensions. Les conducteurs flottants peuvent présenter une forme de L. Les conducteurs flottants peuvent être alignés et orientés identiquement. Les conducteurs flottants peuvent présenter une forme de croix latine ou de T.

Dans un mode de réalisation de l'invention, les plots métallisés comprennent une couche supérieure à base d'aluminium.

Dans un mode de réalisation de l'invention, les conducteurs flottants comprennent de l'aluminium ou du cuivre. Les conducteurs flottants peuvent comprendre une couche supérieure à base d'aluminium ou de cuivre.

Dans un mode de réalisation de l'invention, les rectangles sont de largeur inférieure à 2 µm.

Dans un mode de réalisation de l'invention, les rectangles sont de longueur comprise entre 2 et 10 µm, préférablement entre 4 et 6 µm.

Dans un mode de réalisation de l'invention, le taux de métallisation de la surface sur laquelle sont prévus les conducteurs flottants est inférieur à 35%, préférablement inférieur à 25%, avantageusement compris entre 10 et 20%.

Dans un mode de réalisation de l'invention, le niveau de métallisation est un niveau d'interconnexion.

Dans une autre mode de réalisation de l'invention, le niveau de métallisation est un niveau de grille. En effet, le niveau des grilles de transistor d'un circuit intégré formé au-dessus du substrat comprend une densité locale variable de métal qui pose des problèmes de fabrication similaires à ceux des niveaux de métallisation des interconnexions. On prévoit donc d'y disposer des conducteurs flottants et l'invention s'y applique avec des avantages similaires à ceux qui sont offerts pour les niveaux de métallisation des interconnexions. Ainsi, les conducteurs peuvent être des lignes conductrices de niveaux de métallisation ou des connexions au niveau du polysilicium de la grille.

Le circuit pourra avantageusement comprendre une pluralité de niveaux de métallisation. On entend par niveau de métallisation, une couche conductrice délimitée par un plan inférieur et un plan supérieur parallèle. Le conducteur flottant est disposé dans la couche conductrice entre le plan inférieur et le plan supérieur. Une ligne conductrice d'un niveau de métallisation est disposée parallèlement à certaines lignes conductrices du même niveau de métallisation et perpendiculairement aux autres lignes conductrices du même niveau de métallisation.

L'invention facilite l'analyse du circuit après fabrication et les interventions en vue de modifications, tout en conservant un dessin simple des conducteurs flottants pour maintenir une taille raisonnable de fichier de stockage desdits dessins.

La présente invention sera mieux comprise à l'étude de la description détaillée de quelques modes de réalisation pris à titre d'exemples nullement limitatifs et illustrés par les dessins annexés, sur lesquels:
- la figure 1 est une vue schématique de dessus d'un niveau de métallisation selon un premier mode de réalisation de l'invention; et
- les figures 2 et 3 sont des vues similaires à la figure 1, selon d'autres modes de réalisation de l'invention.

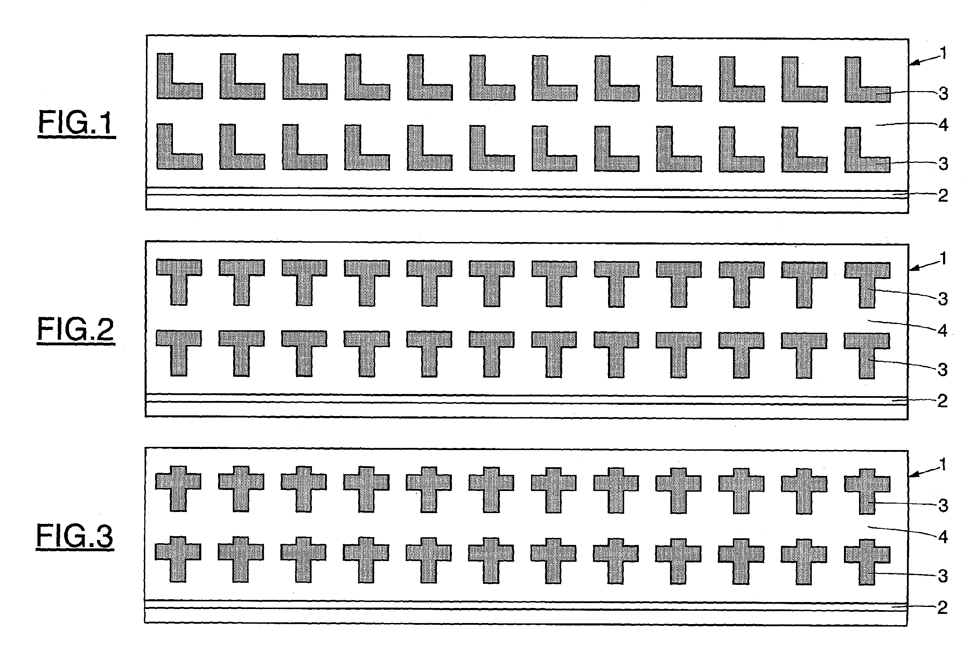

Sur la figure 1, on voit une portion d'un niveau de métallisation. Toutefois, la figure 1 illustre également un niveau de grille qui peut présenter la même disposition.

Un circuit intégré 1 comprend un niveau de métallisation pourvu d'une ligne conductrice 2, présentant une direction générale allongée avec des bords longitudinaux parallèles. Bien entendu, un niveau de métallisation comprend, en règle générale, un grand nombre de lignes conductrices dont une seule a été représentée ici pour des raisons de clarté des dessins.

À proximité d'un bord de la ligne conductrice 2 et parallèlement à celle-ci, est disposée une rangée de conducteurs flottants 3 en forme de L formée de deux rectangles de dimensions égales, disposés perpendiculairement l'un par rapport à l'autre. L'un des rectangles est parallèle au bord de la ligne conductrice 2. Toutefois, les rectangles peuvent être obliques. La largeur d'un rectangle pourra être comprise entre 0,2 et 2 µm, préférablement entre 0,8 et 1,8 µm, par exemple de l'ordre de 1,5 µm. La longueur d'un rectangle pourra être comprise entre 2 et 10 µm, préférablement entre 4 et 6 µm, par exemple de l'ordre de 5 µm. La distance entre les extrémités de rectangles de conducteurs flottants d'une même rangée pourra être comprise entre 2 et 10 µm, préférablement entre 3 et 6 µm, par exemple de l'ordre de 4 µm.

Le niveau de métallisation auquel appartiennent la ligne conductrice 2 et les conducteurs flottants 3 se complète par du matériau diélectrique 4 disposé entre ces éléments et par un plot métallisé 5.

Les conducteurs flottants conventionnels occupent 35% de la surface pour des carrés de 2,5 µm de côté espacés de 2 µm. La plus grande surface libre carrée entre les conducteurs flottants fait 2 µm de côté, soit 4 µm². Avec les conducteurs flottants selon l'invention, le taux de remplissage est alors de 15,75%. La plus grande surface libre carrée entre les conducteurs flottants fait 7,5 µm de côté, soit 56,25 µm². On parvient ainsi à augmenter de plus de 1300% la surface libre à travers laquelle les photons peuvent passer pour des opérations de vérification et/ou de modification du circuit.

Dans une variante, on peut prendre des conducteurs flottants de 1 µm de largeur et de 6 µm de longueur espacés de 2 µm. La plus grande surface libre carrée entre les conducteurs flottants fait 8 µm de côté, 64 µm² de surface, soit une augmentation de 1500% de la surface libre.

Sur la figure 2, est illustrée une variante de la figure 1, dans laquelle les conducteurs flottants sont en forme de T, un rectangle d'un conducteur flottant joignant une extrémité de l'autre rectangle par son milieu. La forme des conducteurs flottants permet une orientation du circuit intégré.

Sur la figure 3, est illustrée une variante de la figure 1, dans laquelle les conducteurs flottants sont en forme de croix latine, un rectangle d'un conducteur flottant joignant le milieu de l'autre rectangle environ au tiers de sa longueur. La forme des conducteurs flottants permet une orientation du circuit intégré.

Bien entendu, toute forme de conducteur flottant intermédiaire entre les précédentes convient. Une forme de croix grecque est moins favorable en raison de sa symétrie selon deux axes coplanaires perpendiculaires. L'un des rectangles peut être carré et l'autre rectangle non carré. De façon plus générale, toute forme géométrique formée à partir d'au moins deux rectangles et présentant moins de deux axes de symétrie coplanaires convient.

On peut aussi envisager dans le cadre de l'invention, des conducteurs flottants formés à partir de trois rectangles, par exemple en U, en croix de Lorraine, etc. Toutefois, ces formes plus complexes nécessitent des fichiers de stockage plus volumineux.

Grâce à la présence de conducteurs flottants de forme orientée et prévue pour dégager des surfaces libres importantes, lesdits conducteurs flottants sont aptes à remplir une fonction de marques d'alignement et permettent une vérification du circuit par procédé photonique et/ou ionique, y compris dans des technologies à faible largeur de lignes conductrices, telles que HCMOS 9 ou HCMOS 10.

La réalisation des conducteurs flottants, selon l'invention, ne nécessite pas d'étape de fabrication particulière ou supplémentaire et est donc économique.

En effet, la génération d'un circuit intégré numérique se divise en général en quatre étapes générales. Une première étape de conception, une deuxième étape de validation du circuit conçu par modélisation et simulation électrique avec de possibles modifications de la conception, une troisième étape d'ajout des conducteurs flottants lors de la génération du masque de gravure, et une quatrième étape de réalisation du composant. L'ajout des conducteurs flottants est effectué par un procédé conventionnel mais selon les spécificités géométriques de l'invention.

L'invention propose donc une nouvelle géométrie pour les conducteurs flottants avec une procédure d'intégration de ces conducteurs flottants qui peut être conservée.

L'invention s'applique également aux circuits intégrés analogiques où des conducteurs flottants sont parfois prévus en amont de la génération du masque de gravure, pour des raisons électriques.

## Revendications

1. Circuit intégré (1) comprenant au moins un niveau de métallisation, équipé de conducteurs flottants (3), au moins une partie des conducteurs flottants étant **caractérisés par le fait qu'**ils présentent une forme de L ou de T.

2. Circuit selon la revendication 1, **caractérisé par le fait que** les conducteurs flottants (3) sont alignés et orientés identiquement.

3. Circuit selon l'une quelconque des revendications précédentes, **caractérisé par le fait que** des plots métallisés (5) comprennent une couche supérieure à base d'aluminium.

4. Circuit selon l'une quelconque des revendications précédentes, **caractérisé par le fait que** les conducteurs flottants (3) comprennent de l'aluminium.

5. Circuit selon la revendication 4, **caractérisé par le fait que** les conducteurs flottants (3) comprennent une couche supérieure à base d'aluminium ou de cuivre.

6. Circuit selon l'une quelconque des revendications précédentes, **caractérisé par le fait que** les rectangles sont de largeur inférieure à 2µm.

7. Circuit selon l'une quelconque des revendications précédentes, **caractérisé par le fait que** les rectangles sont de longueur comprise entre 2 et 10 µm, préférablement entre 4 et 6 µm.

8. Circuit selon l'une quelconque des revendications précédentes, **caractérisé par le fait que** le taux de métallisation de la surface sur laquelle sont prévus les conducteurs flottants est inférieur à 35 %, préférablement inférieur à 25 %, avantageusement compris entre 10 et 20 %.
